# EUROPÄISCHE PATENTSCHRIFT

(11) **EP 2 857 832 B1**
(45) Veröffentlichungstag und Bekanntmachung des Hinweises auf die Patenterteilung: **25.07.2018**
(21) Anmeldenummer: 14003405.9
(22) Anmeldetag: 02.10.2014
(51) Int. Cl.: G01N 27/414

(54) **Schichtsystem**
Layer system
Système de couche

(30) Priorität: 05.10.2013 DE 102013016330
(43) Veröffentlichungstag der Anmeldung: 08.04.2015
(73) Patentinhaber: TDK-Micronas GmbH, 79108 Freiburg (DE)
(72) Erfinder: Wilbertz, Christoph, 79194 Gundelfingen (DE); Zimmermann, Dominik, 79194 Freiburg (DE)
(74) Vertreter: Koch Müller Patentanwaltsgesellschaft mbH

(56) Entgegenhaltungen:
- EP-A2- 2 372 355
- WO-A2-2004/032197
- DE-A1-102012 022 136
- Li Qiang Zhu ET AL: "Dual functions of anti-reflectance and surface passivation of the atomic layer deposited Al 2 O 3 films on crystalline silicon substrates", , 3. Juli 2012 (2012-07-03), XP055156205, Gefunden im Internet: URL:http://arxiv.org/ftp/arxiv/papers/1207 /1207.0619.pdf [gefunden am 2014-12-02]
- WOLLENSTEIN J ET AL: "Cobalt oxide based gas sensors on silicon substrate for operation at low temperatures", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, CH, Bd. 93, Nr. 1-3, 1. August 2003 (2003-08-01), Seiten 442-448, XP004437136, ISSN: 0925-4005, DOI: 10.1016/S0925-4005(03)00168-0
- GERGINTSCHEW Z ET AL: "The capacitively controlled field effect transistor (CCFET) as a new low power gas sensor", SENSORS AND ACTUATORS B: CHEMICAL: INTERNATIONAL JOURNAL DEVOTED TO RESEARCH AND DEVELOPMENT OF PHYSICAL AND CHEMICAL TRANSDUCERS, ELSEVIER S.A, CH, Bd. 36, Nr. 1, 1. Oktober 1996 (1996-10-01), Seiten 285-289, XP004061082, ISSN: 0925-4005, DOI: 10.1016/S0925-4005(97)80083-4

## Beschreibung

Die Erfindung betrifft ein Schichtsystem gemäß dem Oberbegriff des Patentanspruchs 1.
Aus der DE 689 24 140 T2 ist eine Dünnfilm-Sensorstruktur mit Platin auf Siliziumnitrid bekannt, wobei die Dünnfilmschicht aus Metalloxid auf der Siliziumnitridschicht angeordnet und die Dünnfilmschicht mit Platin abgedeckt ist. Aus Wöllenstein et al., "Cobalt oxide based gas sensors on silicon substrate for operation at low temperatures", Sensors and Actuators B 93 (2003), Seiten 442-448 ist ein Gassensor mit einer Dünnfilmschicht auf einem Siliziumsubstrat bekannt. Ein Verfahren zur Herstellung von texturiertem Silizium ist aus der US 4 137 123 B bekannt. Hierbei wird mit einer verdünnten KOH Ätzung die Oberfläche bearbeitet, um den Reflexionsgrad der Oberfläche zu verringern. Aus Li Quiang Zhu et al., " Dual functions of antireflectance and surface passivation of the atomic layer deposited Al2O3 films on crystalline silicon substrates", arXiv: 1207.0619vl [cond-mat.matrl-sci] (2012) wird zur Passivierung und zur Verringerung des Reflexionsgrads eine Dünnfilmschicht auf die Oberfläche eines Siliziumsubstrats aufgebracht.
Des Weiteren ist aus der EP 1 707 952 A1 ein in einen Gassensor integriertes Schichtsystem bekannt. Gassensoren sind auch aus der EP 2 372 355 A2, der DE 10 2012 022 136 A1 und aus Z. Gergintschew et al., "The capacitively controlled field effect transistor (CCFET) as a new low power gas sensor", Sensors and Actuators B 35-36 (1996), Seiten 285-289 bekannt. Aus der EP 2 372 355 A2 ist zudem bekannt, das Siliziumsubstrat zu texturieren, um die Sensitivität des Sensors zu erhöhen. Auch ist aus der WO 2004 / 032 197 A2 ein texturierter, metallisch leitender Haftvermittlerfilm bekannt, um die Haftung einer Dünnfilmschicht auf einem Siliziumsubstrat zu erhöhen. Vor diesem Hintergrund besteht die Aufgabe der Erfindung darin, eine Vorrichtung anzugeben, die den Stand der Technik weiterbildet.
Die Aufgabe wird durch ein Schichtsystem mit den Merkmalen des Patentanspruchs 1 gelöst. Vorteilhafte Ausgestaltungen der Erfindung sind Gegenstand von Unteransprüchen.

Es sei angemerkt, dass die Oberfläche aufgrund der Textur eine Mikrorauigkeit aufweist und die Dünnfilmschicht sich an die Oberfläche der Textur anschmiegt, vorzugsweise konform und hierbei die Spitzen der Textur vollständig bedeckt sind. Des Weiteren sei angemerkt, dass das Siliziumsubstrat vorzugsweise als Halbleiterwafer ausgebildet ist und die Dünnfilmschicht mittels eines Siebdruckverfahrens und / oder anderen Verfahren hergestellt wird. Auf derartigen Siliziumwafern werden im Allgemeinen integrierte Schaltungen ausgebildet. Bevorzugt werden für die Ausbildung der texturierten Oberfläche genau die gleichen Halbleiterwafer verwendet wie im Falle der Herstellung einer integrierten Schaltung.
Ein Vorteil der erfindungsgemäßen Vorrichtung ist es, dass das Siliziumsubstrat mit der texturierten Oberfläche eine derartige Oberflächenrauhigkeit aufweist, dass die Dünnfilmschicht mit der Unterlage eine kraftschlüssige Verbindung eingeht. Hierdurch wird es ermöglicht die spröden Dünnfilmschichten ohne eine Klebeverbindung mit der Siliziumoberfläche zu verbinden. Ein weiterer Vorteil ist, dass die Dünnfilmschichten eine große Oberfläche aufweisen. Hierbei ist es bevorzugt, dass die Dünnfilmschicht eine Dicke kleiner als 500 µm, höchst vorzugsweise eine Dicke kleiner als 100 µm aufweist.
Untersuchungen der Anmelder haben gezeigt, dass es vorteilhaft ist, wenn die texturierte Oberfläche eine pyramidenförmige Topographie aufweist. In einer bevorzugten Ausführungsform sind die Seitenflächen der pyramidenförmigen Textur als 111-Flächen ausgebildet. Ferner weist die Textur an der Oberseite 100-Flächen auf. Derartige pyramidenförmige Topographien lassen sich mit einer KOH Ätzung erzeugen.
Wenn ausgewählte Bereiche der ursprünglichen Oberfläche des Substratwafers mit einer Schutzschicht bedeckt werden, lässt sich die Verteilung der Erhebungen in der Oberflächenebene vorab definieren. Bei Verwendung eines Lithografieprozesses zur Strukturierung der Schutzschicht lässt sich eine Textur mit einer hohen Symmetrie erreichen.
In einer anderen Weiterbildung umfasst die Dünnfilmschicht einen Katalysator. Untersuchungen haben gezeigt, dass es vorteilhaft ist, als Katalysator Platin und / oder Palladium und / oder Rhodium zu verwenden. Gemäß der Erfindung ist zwischen der Dünnfilmschicht und der texturierten Oberfläche eine metallisch leitende Zwischenschicht ausgebildet, die die texturierte Oberfläche teilweise oder vollständig bedeckt. Es versteht sich, dass auf der Oberfläche des Siliziumsubstrats die eine oder mehrere Zwischenschichten eine stoffschlüssige Verbindung mit der Oberfläche des Siliziumsubstrats ausbilden und hiernach die Dünnfilmschicht mit der obersten der Zwischenschichten eine stoffschlüssige Verbindung ausbildet. Demgemäß ist auf der texturierten Oberfläche des Siliziumsubstrates eine Abfolge von mindestens zwei Schichten ausgebildet.
In einer Weiterbildung umfasst die metallisch leitende Zwischenschicht eine Silizidschicht, wobei es bevorzugt ist, dass die Silizidschicht Platin und / oder Titan und / oder Palladium umfasst. In einer weiteren Ausbildung ist die metallisch leitende Zwischenschicht elektrisch angeschlossen. In einer Ausführungsform ist zusätzlich oder anstelle der Zwischenschicht die Dünnfilmschicht elektrisch angeschlossen.
Des Weiteren ist es bevorzugt, dass das texturierte Silizium in dem Schichtbereich eine p- oder eine n-Dotierung aufweist. Hierzu ist vorzugsweise in dem Schichtbereich eine n- oder p-Wanne ausgebildet.
Vorteilhaft ist, den Schichtbereich als gassensitive Steuerelektrode in einen SGFET oder einen CCFET-Gassensor zu integrieren. Ferner hat es sich als vorteilhaft gezeigt, die Dünnfilmschicht aus Galliumoxid und / oder aus Zinnoxid und / oder aus Bariumtitanat und / oder aus Bariumcarbonat auszubilden.
Vorteilhaft ist, wenn die texturierte Oberfläche Pyramidendeckflächen oder Pyramidenspitzen enthält und zwischen unmittelbar benachbarten Pyramidenspitzen oder Pyramidendeckflächen ein Abstand von 1 µm bis 10 µm ausgebildet ist und die Pyramidendeckflächen oder Pyramidenspitzen zwischen 1 µm und 10 µm hoch sind. Gemäß der Erfindung weist die metallisch leitende Zwischenschicht eine Texturierung mit einem Texturabstand von 0,1 µm bis 1 µm und einer Texturtiefe von 0,1 µm bis 1 µm auf, wobei der Texturabstand und die Texturtiefe jeweils kleiner als die von der Oberfläche der Siliziumschicht sind.

In einer Weiterbildung ist die Dünnfilmschicht polykristallin ausgebildet und die Korngrößen der Dünnfilmschicht sind kleiner als 2 µm.
Die Erfindung wird nachfolgend unter Bezugnahme auf die Zeichnungen näher erläutert. Hierbei werden gleichartige Teile mit identischen Bezeichnungen beschriftet. Die dargestellten Beispiele und die dargestellte Ausführungsform sind stark schematisiert, d.h. die Abstände und laterale und vertikale Erstreckung sind nicht maßstäblich und weisen, sofern nicht anders angegeben auch keine ableitbare geometrische Relation zueinander auf. Darin zeigen die:
- Figur 1a: eine Querschnittsansicht auf ein nicht beanspruchtes erstes Beispiel eines Schichtaufbaus,
- Figur 1b: eine Querschnittsansicht auf ein nicht beanspruchtes zweites Beispiel eines Schichtaufbaus,
- Figur 1c: eine Querschnittsansicht auf ein nicht beanspruchtes drittes Beispiel eines Schichtaufbaus,
- Figur 2: eine elektronenmikroskopische Aufnahme auf eine texturierte Oberfläche eines Siliziumsubstrats,
- Figur 3: eine Prinzipskizze eines CCFET-Transistors unter Verwendung einer Elektrode mit einem Schichtaufbaus eines der Beispiele, dargestellt in der Fig. 1a - Fig.1c,
- Figur 4: eine Querschnittsansicht auf eine erfindungsgemäße Ausführungsform des Schichtaufbaus mit einer texturierten Zwischenschicht.

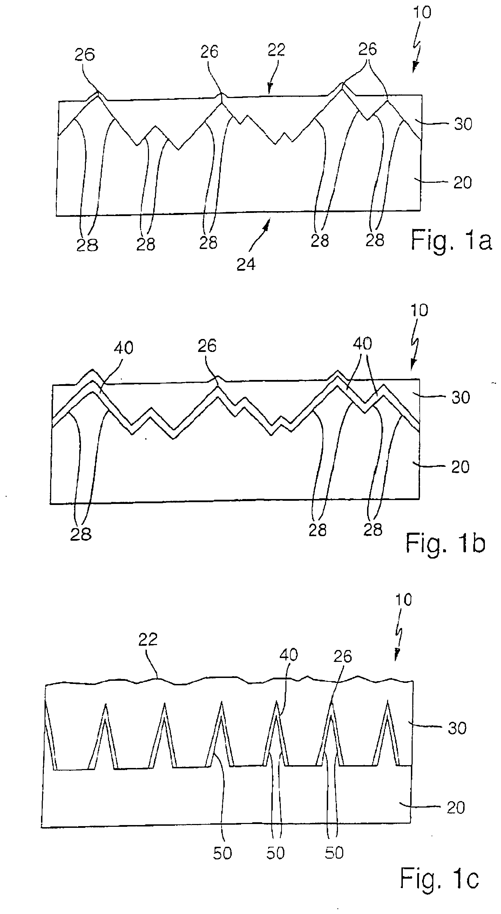

Die Abbildung der Figur 1a zeigt eine Querschnittsansicht eines nicht beanspruchten ersten Beispiels eines Schichtsystems 10, aufweisend ein monokristallines Siliziumsubstrat 20, mit einer Vorderseite 22 und einer Rückseite 24. Auf der Vorderseite 22 des Siliziumsubstrats 20 ist eine texturierte Oberfläche ausgebildet. Hierbei weist die texturierte Oberfläche eine Topographie mit unterschiedlichen Höhen auf. Es sei angemerkt, dass die Topographie vielfältig geformte Erhebungen zeigt, wobei aus Gründen der Übersichtlichkeit die Erhebungen vereinfacht als Spitzen 26 dargestellt sind. Indem die Textur vorzugsweise mittels einer KOH-Ätzung erzeugt wird, ist die Topographie der texturierten Oberfläche pyramidenförmig, d.h. die Seitenflächen 28 der pyramidenförmige Erhebungen bzw. Spitzen 26 sind als 111-Flächen ausgebildet. Sofern die Erhebungen der Textur Plateaus ausbilden, sind an der Oberseite 100-Flächen - nicht dargestellt - ausgebildet. Es sei des Weiteren angemerkt, dass die Spitzen eine unterschiedliche Höhe aufweisen. Des Weiteren sind die Spitzen unterschiedlich zueinander entfernt. Bevorzugt ist, dass zwischen unmittelbar benachbarten Pyramidenspitzen oder Pyramidendeckflächen ein Abstand von 1 µm bis 10 µm ausgebildet ist und die Pyramidendeckflächen oder Pyramidenspitzen eine Höhe zwischen 1 µm und 10 µm bezogen auf den Fuß der Pyramide aufweisen. Ferner weist das Siliziumsubstrat 20, welche im Allgemeinen als Vorderseite eines Silizium-Halbleiterwafer ausgebildet ist, eine n- oder p-Dotierstoffkonzentration, vorzugsweise von Phosphor oder Bor, in einem Bereich von einigen 10e17 N/cm³ bis wenigen 10e19 N/cm³ auf. Es versteht sich, dass die monokristalline Schicht auch epitaktisch gewachsen sein kann. Das Siliziumsubstrat 20 ist zusätzlich zur oder anstelle der Dünnfilmschicht 30 elektrisch angeschlossen - nicht dargestellt. Ferner sei angemerkt, dass neben den dargestellten texturierten Gebieten auf der Siliziumsubstratschicht 20 auch nicht texturierte Gebiete - nicht dargestellt - ausgebildet sein können. Um solche Gebiete voneinander zu separieren, werden die bekannten photolithographischen Verfahren angewendet.
Auf der texturierten Oberfläche ist eine Dünnfilmschicht 30 aus einem Metalloxid und / oder einer Oxidkeramik ausgebildet, wobei die Dünnfilmschicht 30 die texturierte Oberfläche vollständig bedeckt und bevorzugt Galliumoxid und / oder Zinnoxid und / oder Bariumtitanat und / oder Bariumcarbonat enthält. Zusätzlich ist es vorteilhaft, wenn die Dünnfilmschicht 30 einen Katalysator umfasst. Besonders vorteilhaft ist es, wenn der Katalysator Platin und / oder Palladium und / oder Rhodium aufweist. Die Dünnfilmschicht 30 weist eine im Bereich der Metalle liegende Leitfähigkeit auf. Ferner ist die Dünnfilmschicht elektrisch angeschlossen. Es ist bevorzugt, dass die Dünnfilmschicht 30 an der dicksten Stelle eine Dicke kleiner als 500 µm, höchst vorzugsweise kleiner als 50 µm aufweist. Vorzugsweise bildet die Dünnfilmschicht 30 eine stoffschlüssige Verbindung mit der Unterlage aus. Vorteilhaft ist, wenn die Dünnfilmschicht polykristallin ausgebildet ist und die Korngrößen der Dünnfilmschicht kleiner als 2 µm sind.

In der Abbildung der Figur 1b ist eine Querschnittsansicht eines nicht beanspruchten zweiten Beispiels des Schichtsystems 10 dargestellt. Nachfolgend werden nur die Unterschiede zu den Erläuterungen in Zusammenhang mit der Figur 1a angeführt. Zwischen der Dünnfilmschicht 30 und der Oberfläche auf der Vorderseite 22 des Siliziumsubstrats 20 ist eine metallisch leitende Zwischenschicht 40 ausgebildet. Die Zwischenschicht 40 bedeckt die Oberfläche, also auch die Spitzen des Siliziumsubstrats 20, vorzugsweise vollständig und konform. Die Zwischenschicht 40 bildet einerseits eine stoffschlüssige Verbindung mit der Unterlage, also mit der Oberfläche der Siliziumsubstratschicht 20 als auch eine stoffschlüssige Verbindung mit der auf der Zwischenschicht 40 aufliegenden Dünnfilmschicht 30 aus.
Es versteht sich, dass die metallisch leitende Zwischenschicht 40 elektrisch angeschlossen ist - nicht dargestellt. Der elektrische Anschluss der Zwischenschicht 40 kann zusätzlich oder alternativ zu den elektrischen Anschlüssen des Siliziumsubstrats 20 und / oder der Dünnfilmschicht 30 ausgebildet sein. Der elektrische Anschluss kann in den texturierten oder, falls vorhanden, in nicht texturierten Gebieten des Siliziumsubstrats 20 ausgebildet sein. Vorzugsweise umfasst die metallisch leitende Zwischenschicht eine Silizidschicht aus Platin und / oder Wolfram und / oder Titan und / oder Palladium.

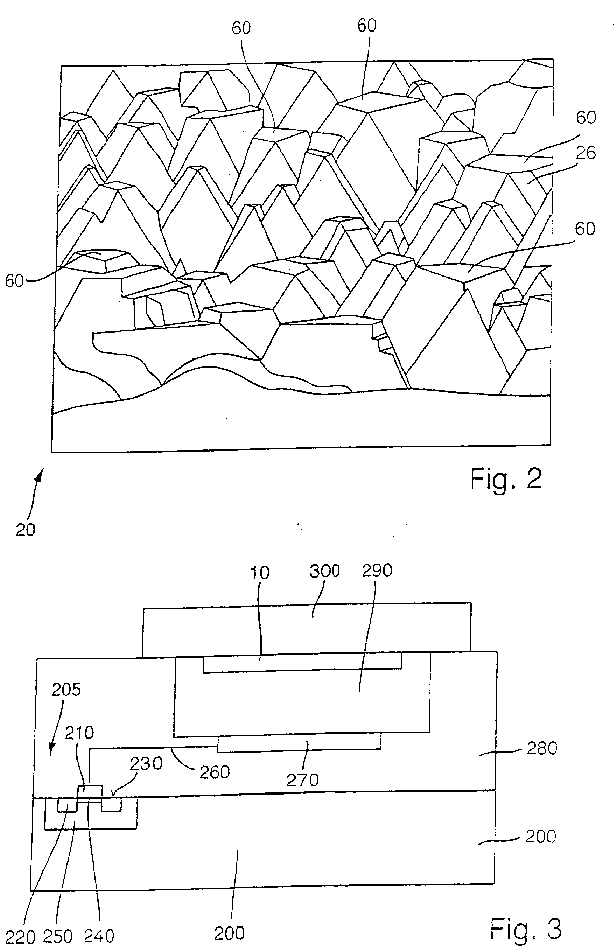

In der Abbildung der Figur 1c ist eine Querschnittsansicht eines nicht beanspruchten dritten Beispiels des Schichtsystems 10 dargestellt. Nachfolgend werden nur die Unterschiede zu den Erläuterungen in Zusammenhang mit der Figur 1b angeführt. Die Texturierung der Oberfläche des Siliziumsubstrats 20 bildet nun eine regelmäßige Topographie aus. Aus der Oberfläche des Siliziumsubstrats 20 ragen zueinander gleichmäßig beabstandete Spitzen 26 heraus. Die Seitenflächen der Spitzen werden nicht notwendig von 111-Flächen gebildet. Zur Erzeugung der Spitzen 26 werden insbesondere photolithographische Verfahren, d. h. Maskenprozesse in Verbindung mit Trockenätzverfahren verwendet.
In der Abbildung der Figur 2 ist eine elektronenmikroskopische Aufnahme auf eine texturierte Oberfläche des Siliziumsubstrats 20 unmittelbar nach der KOH-Ätzung dargestellt. Hierdurch fehlt sowohl die Dünnfilmschicht 30 als auch die Zwischenschicht 40. Folgenden werden nur die Unterschiede zu den Erläuterungen in Zusammenhang mit der Figur 1a angeführt. Es zeigt sich die pyramidenförmige Struktur, wobei neben den Spitzen nunmehr auch Plateaus 60 unterschiedlicher Größe ausgebildet sind.
In der Abbildung der Figur 3 ist eine Prinzipskizze eines CCFET-Transistors dargestellt unter Verwendung einer Elektrode mit einem Schichtaufbau eines der Beispiele in einer der Figuren 1a - Fig.lc. Im Folgenden werden nur die Unterschiede zu den Erläuterungen in Zusammenhang mit den Darstellungen in den vorangegangenen Figuren angeführt. In der Oberseite eines Siliziumwafers 200 ist ein MOS-Transistor 205 mit einem Gate 210, einer Source 220 und einer Drain 230 ausgebildet. Zwischen Source 220 und der Drain 230 ist ein Kanalgebiet 240 angeordnet. Der MOS-Transistor 205 ist einer Wanne 250 angeordnet. Das Gate 210 ist mit einer Leitung 260 mit einer ersten Elektrode 270 verschaltet. Auf der Oberseite des Siliziumwafers 200 ist ein mehrlagiger dielektrischer Schichtaufbau 280 angeordnet. Der Schichtaufbau 280 bildet eine Kavität 290 aus. An der Bodenfläche der Kavität 290 ist die erste Elektrode 270 angeordnet. Die Kavität wird bedeckt von einer Tragstruktur 300. Die Tragstruktur 300 weist an der Unterseite das Schichtsystem 10 auf, wobei die Oberfläche des Siliziumsubstrats 20 nach unten in Richtung der ersten Elektrode 270 zeigt. Das Schichtsystem 10 bildet eine Gegenelektrode zu der ersten Elektrode 270 aus. Beide Elektroden bilden zusammen einen Kondensator aus. Sofern die Dünnfilmschicht 30 gassensitive Eigenschaften aufweist, ändert sich je nach Anlagerung von bestimmten Gasmolekülen das Potential an der der Kavität 290 zugewandten Oberfläche des Schichtsystems 10 des Kondensators und hierdurch ändert sich die Leitfähigkeit des Kanalgebiets 240. Zusammengefasst ist das Schichtsystem 10 als gassensitive Steuerelektrode in einen CCFET-Gassensor integriert.

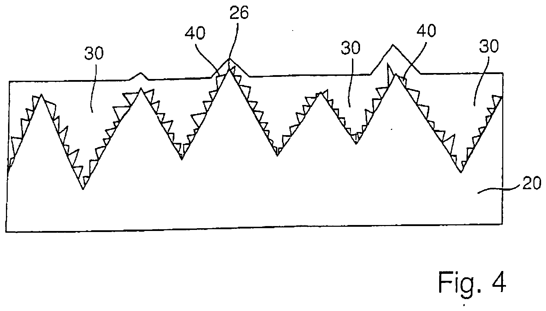

In der Abbildung der Figur 4 ist eine Querschnittsansicht auf eine erfindungsgemäße Ausführungsform des Schichtaufbaus mit einer texturierten Zwischenschicht dargestellt. Im Folgenden werden nur die Unterschiede zu den Erläuterungen in Zusammenhang mit der Darstellung des Beispiels der Figur 1b angeführt. Die Zwischenschicht 40 weist ebenfalls eine Texturierung auf, wobei der Texturabstand zwischen 0,1 µm bis 1 µm und die Tiefe der Textur zwischen 0,1 µm bis 1 µm beträgt. Der Texturabstand und die Texturtiefe sind jeweils kleiner als der Texturabstand und die Texturtiefe der Oberfläche des Siliziumsubstrats 20.

## Patentansprüche

1. Schichtsystem (10) mit einem Schichtbereich, wobei der Schichtbereich ein monokristallines Siliziumsubstrat (20) mit einer Vorderseite (22) und einer Rückseite (24),
eine Dünnfilmschicht (30) aus einem Metalloxid und/oder einer Oxidkeramik und eine Zwischenschicht (40) aufweist, **dadurch gekennzeichnet, dass**
- die Vorderseite (22) des monokristallinen Siliziumsubstrats (20) als eine texturierte Oberfläche ausgebildet ist und die texturierte Oberfläche eine Topographie mit unterschiedlichen Höhen aufweist,
- die Dünnfilmschicht (30) auf der texturierten Oberfläche ausgebildet ist und die texturierte Oberfläche bedeckt,
- die Zwischenschicht (40) metallisch leitend ist und zwischen der Dünnfilmschicht (30) und der texturierten Oberfläche die metallisch leitende Zwischenschicht (40) die texturierte Oberfläche teilweise oder vollständig bedeckt und
- die metallisch leitende Zwischenschicht (40) eine Texturierung aufweist mit einem Texturabstand von 0,1 µm bis 1 µm und einer Texturtiefe von 0,1 µm bis 1 µm und der Texturabstand und die Texturtiefe jeweils kleiner als die an der texturierten Oberfläche des monokristallinen Siliziumsubstrats (20) ist.

2. Schichtsystem (10) nach Anspruch 1, **dadurch gekennzeichnet, dass** die texturierte Oberfläche eine pyramidenförmige Topographie aufweist.

3. Schichtsystem (10) nach Anspruch 1 oder Anspruch 2, **dadurch gekennzeichnet, dass** die Dünnfilmschicht (30) einen Katalysator umfasst.

4. Schichtsystem (10) nach Anspruch 3, **dadurch gekennzeichnet, dass** der Katalysator Platin und / oder Palladium und / oder Rhodium aufweist.

5. Schichtsystem (10) nach einem der Ansprüche 1 bis 4, **dadurch gekennzeichnet, dass** die Dünnfilmschicht (30) eine Dicke kleiner als 500 µm aufweist.

6. Schichtsystem (10) nach einem der Ansprüche 1 bis 5, **dadurch gekennzeichnet, dass** die metallisch leitende Zwischenschicht (40) eine Silizidschicht umfasst.

7. Schichtsystem (10) nach Anspruch 6, **dadurch gekennzeichnet, dass** die Silizidschicht Platin und / oder Titan und / oder Palladium umfasst.

8. Schichtsystem (10) nach einem der Ansprüche 1 bis 7, **dadurch gekennzeichnet, dass** die metallisch leitende Zwischenschicht (40) einen elektrischen Anschluss aufweist.

9. Schichtsystem (10) nach einem der vorstehenden Ansprüche, **dadurch gekennzeichnet, dass** die Dünnfilmschicht (30) einen elektrischen Anschluss aufweist.

10. Schichtsystem (10) nach einem der vorstehenden Ansprüche, **dadurch gekennzeichnet, dass** das monokristalline Siliziumsubstrat (20) in dem Schichtbereich eine p- oder eine n-Dotierung aufweist.

11. SGFET- oder CCFET-Gassensor aufweisend ein Schichtsystem (10) nach einem der vorstehenden Ansprüche, **dadurch gekennzeichnet, dass** der Schichtbereich als gassensitive Steuerelektrode in den SGFET- oder den CCFET-Gassensor integriert ist.

12. Schichtsystem (10) nach einem der Ansprüche 1-10 oder SGFET- oder CCFET-Gassensor nach Anspruch 11, **dadurch gekennzeichnet, dass** die texturierte Oberfläche des monokristallinen Siliziumsubstrats (20) eine pyramidenförmige Textur aufweist, deren Seitenflächen (28) 111-Flächen sind und deren Oberseite 100-Flächen (60) aufweist.

13. Schichtsystem (10) nach einem der Ansprüche 1-10 oder 12 oder SGFET- oder CCFET-Gassensor nach Anspruch 11, **dadurch gekennzeichnet, dass** die Dünnfilmschicht (30) Galliumoxid und / oder Zinnoxid und / oder Bariumtitanat und / oder Bariumcarbonat enthält.

14. Schichtsystem (10) nach einem der Ansprüche 1-10, 12 oder 13 oder SGFET- oder CCFET-Gassensor nach Anspruch 11, **dadurch gekennzeichnet, dass** die texturierte Oberfläche Pyramidendeckflächen oder Pyramidenspitzen enthält und zwischen unmittelbar benachbarten Pyramidenspitzen oder Pyramidendeckflächen ein Abstand von 1 µm bis 10 µm ausgebildet ist und die Pyramidendeckflächen oder Pyramidenspitzen zwischen 1 µm und 10 µm hoch sind.

15. Schichtsystem (10) nach einem der Ansprüche 1-10 oder 12-14 oder SGFET- oder CCFET-Gassensor nach Anspruch 11, **dadurch gekennzeichnet, dass** die Dünnfilmschicht (30) polykristallin ausgebildet ist und die Korngrößen der Dünnfilmschicht (30) kleiner als 2 µm sind.

16. Schichtsystem (10) nach einem der Ansprüche 1-10 oder 12-15 oder SGFET- oder CCFET-Gassensor nach Anspruch 11, **dadurch gekennzeichnet, dass** die Dünnfilmschicht (30) die texturierte Oberfläche vollständig bedeckt.

## Claims

1. Layer system (10) with a layer region, wherein the layer region comprises a monocrystalline silicon substrate (20) with a front side (22) and a rear side (24), a thin-film layer (30) of a metal oxide and/or an oxide ceramic and an intermediate layer (40), **characterised in that**
- the front side (22) of the monocrystalline silicon substrate (20) is formed as a textured surface and the textured surface has a topography with different heights,
- the thin-film layer (30) is formed on the textured surface and covers the textured surface,
- the intermediate layer (40) has metallic conductivity and between the thin-film layer (30) and the textured surface the metallically conductive intermediate layer (40) partly or completely covers the textured surface and
- the metallically conductive intermediate layer (40) has a texturing with a texture interval of 0.1 microns to 1 micron and a texture depth of 0.1 microns to 1 micron and the texture interval and the texture depth are each smaller than that at the textured surface of the monocrystalline silicon substrate (20).

2. Layer system (10) according to claim 1, **characterised in that** the textured surface has a pyramidal topography.

3. Layer system (10) according to claim 1 or claim 2, **characterised in that** the thin-film layer (30) comprises a catalyser.

4. Layer system (10) according to claim 3, **characterised in that** the catalyser comprises platinum and/or palladium and/or rhodium.

5. Layer system (10) according to any one of claims 1 to 4, **characterised in that** the thin-film layer (40) has a thickness of less than 500 microns.

6. Layer system (10) according to any one of claims 1 to 5, **characterised in that** the metallically conductive intermediate layer (40) comprises a silicide layer.

7. Layer system (10) according to claim 6, **characterised in that** the silicide layer comprises platinum and/or titanium and/or palladium.

8. Layer system (10) according to any one of claims 1 to 7, **characterised in that** the metallically conductive intermediate layer (40) has an electrical connection.

9. Layer system (10) according to any one of the preceding claims, **characterised in that** the thin-film layer (30) has an electrical connection.

10. Layer system (10) according to any one of the preceding claims, **characterised in that** the monocrystalline silicon substrate (20) has a p doping or an n doping in the layer region.

11. SGFET or CCFET gas sensor comprising a layer system (10) according to any one of the preceding claims, **characterised in that** the layer region is integrated as a gassensitive control electrode in the SGFET or CCFET gas sensor.

12. Layer system (10) according to any one of claims 1 to 10 or SGFET or CCFET gas sensor according to claim 11, **characterised in that** the textured surface of the monocrystalline silicon substrate (20) has a pyramidal texture, the side surfaces (28) of which are 111 surfaces and the upper side of which has 100 surfaces (60).

13. Layer system (10) according to any one of claims 1 to 10 or 12 or SGFET or CCFET gas sensor according to claim 11, **characterised in that** the thin-film layer (30) contains gallium oxide and/or tin oxide and/or barium titanate and/or barium carbonate.

14. Layer system (10) according to any one of claims 1 to 10, 12 or 13 or SGFET or CCFET gas sensor according to claim 11, **characterised in that** the textured surface contains pyramidal top surfaces or pyramidal peaks and a spacing of 1 micron to 10 microns is formed between directly adjacent pyramidal peaks or pyramidal top surfaces and the pyramidal top surfaces or pyramidal peaks are between 1 micron and 10 microns high.

15. Layer system (10) according to any one of claims 1 to 10 or 12 to 14 or SGFET or CCFET gas sensor according to claim 11, **characterised in that** the thin-film layer (30) is formed to be polycrystalline and the grain sizes of the thin-film layer (30) are smaller than 2 microns.

16. Layer system (10) according to any one of claims 1 to 10 or 12 to 15 or SGFET or CCFET gas sensor according to claim 11, **characterised in that** the thin-film layer (30) completely covers the textured surface.

## Revendications

1. Système de couçhe (10) avec une région stratifiée, dans lequel la région stratifiée présente
un substrat de silicium monocristallin (20) avec un côté avant (22) et un côté arrière (24),
une couche de film mince (30) en un oxyde métallique et/ou un oxyde céramique et
une couche intermédiaire (40),
**caractérisé en ce que**
- le côté avant (22) du substrat de silicium monocristallin (20) est réalisé sous forme d'une surface texturée et la surface texturée présente une topographie avec des hauteurs différentes,
- la couche de film mince (30) est formée sur la surface texturée et recouvre la surface texturée,
- la couche intermédiaire (40) est métallique conductrice et entre la couche de film mince (30) et la surface texturée, la couche intermédiaire métallique conductrice (40) recouvre partiellement ou entièrement la surface texturée et
- la couche intermédiaire métallique conductrice (40) présente une texturation avec une distance de texture de 0,1 µm à 1 µm et une profondeur de texture de 0,1 µm à 1 µm et la distance de texture et la profondeur de texture sont respectivement plus petites que celles de la surface texturée du substrat de silicium monocristallin (20).

2. Système de couche (10) selon la revendication 1, **caractérisé en ce que** la surface texturée présente une topographie en forme de pyramides.

3. Système de couche (10) selon la revendication 1 ou la revendication 2, **caractérisé en ce que** la couche de film mince (30) comprend un catalyseur.

4. Système de couche (10) selon la revendication 3, **caractérisé en ce que** le catalyseur présente du platine et/ou du palladium et/ou du rhodium.

5. Système de couche (10) selon l'une quelconque des revendications 1 à 4, **caractérisé en ce que** la couche de film mince (30) présente une épaisseur inférieure à 500 µm.

6. Système de couche (10) selon l'une quelconque des revendications 1 à 5, **caractérisé en ce que** la couche intermédiaire métallique conductrice (40) comprend une couche de siliciure.

7. Système de couche (10) selon la revendication 6, **caractérisé en ce que** la couche de siliciure comprend du platine et/ou du titane et/ou du palladium.

8. Système de couche (10) selon l'une quelconque des revendications 1 à 7, **caractérisé en ce que** la couche intermédiaire métallique conductrice (40) présente un raccord électrique.

9. Système de couche (10) selon l'une quelconque des revendications précédentes, **caractérisé en ce que** la couche de film mince (30) présente un raccord électrique.

10. Système de couche (10) selon l'une quelconque des revendications précédentes, **caractérisé en ce que** le substrat de silicium monocristallin (20) présente dans la région stratifiée un dopage p ou un dopage n.

11. Détecteur de gaz à SGFET ou CCFET présentant un système de couche (10) selon l'une quelconque des revendications précédentes, **caractérisé en ce que** la région stratifiée est intégrée en tant qu'électrode de commande sensible au gaz dans le détecteur de gaz à SGFET ou CCFET.

12. Système de couche (10) selon l'une quelconque des revendications 1 à 10 ou détecteur de gaz à SGFET ou CCFET selon la revendication 11, **caractérisé en ce que** la surface texturée du substrat de silicium monocristallin (20) présente une texture en forme de pyramides, dont les faces latérales (28) sont des faces 111 et dont le côté supérieur présente des faces 100 (60).

13. Système de couche (10) selon l'une quelconque des revendications 1 à 10 ou 12 ou détecteur de gaz à SGFET ou CCFET selon la revendication 11, **caractérisé en ce que** la couche de film mince (30) contient de l'oxyde de gallium et/ou de l'oxyde d'étain et/ou du titanate de baryum et/ou du carbonate de baryum.

14. Système de couche (10) selon l'une quelconque des revendications 1 à 10, 12 ou 13 ou détecteur de gaz à SGFET ou CCFET selon la revendication 11, **caractérisé en ce que** la surface texturée contient des faces de sommet de pyramides ou des pointes de pyramides et une distance de 1 µm à 10 µm est formée entre des pointes de pyramides ou des faces de sommet de pyramides immédiatement voisines et les faces de sommet de pyramides ou les pointes de pyramides ont une hauteur comprise entre 1 µm et 10 µm.

15. Système de couche (10) selon l'une quelconque des revendications 1 à 10 ou 12 à 14 ou détecteur de gaz à SGFET ou CCFET selon la revendication 11, **caractérisé en ce que** la couche de film mince (30) est une couche polycristalline et les tailles de grains de la couche de film mince (30) sont inférieures à 2 µm.

16. Système de couche (10) selon l'une quelconque des revendications 1 à 10 ou 12 à 15 ou détecteur de gaz à SGFET ou CCFET selon la revendication 11, **caractérisé en ce que** la couche de film mince (30) recouvre entièrement la surface texturée.
